# EUROPÄISCHE PATENTANMELDUNG

(11) **EP 2 262 355 A2**
(43) Veröffentlichungstag der Anmeldung: **15.12.2010**
(21) Anmeldenummer: 10003965.0
(22) Anmeldetag: 15.04.2010
(51) Int. Cl.: H05K 7/20

(54) **Stromrichteranordnung mit Kühleinrichtung und Herstellungverfahren hierzu**

(30) Priorität: 09.06.2009 DE 102009024370
(71) Anmelder: SEMIKRON Elektronik GmbH & Co. KG, 90431 Nürnberg (DE)
(72) Erfinder: Frey, Tobias, Dr., 91058 Erlangen (DE); Göbl, Christian, 90441 Nürnberg (DE); Radüge, Christian, Dr., 90513 Zirndorf (DE); Sagebaum, Ulrich, 90408 Nürnberg (DE)

(57) **Zusammenfassung**

Die Erfindung betrifft eine Stromrichteranordnung und ein Herstellungsverfahren hierzu mit einer Kühleinrichtung mit einem keramischen Formkörper, der eine Mehrzahl von Seitenflächen, zwei Stirnflächen und eine Mehrzahl von Kühlmedienkanälen aufweist, wobei die Kühlmedienkanäle von der ersten zur zweiten Stirnfläche reichen und mit einer Mehrzahl von Stromrichterschaltungen mit jeweils einer Mehrzahl von voneinander elektrischen isolierten ersten Leiterbahnen und auf mindestens einem auf einer dieser Leiterbahnen angeordneten und schaltungsgerecht verbundenem Leistungshalbeiterbauelement sind. Hier sind zwei Stromrichterschaltungen auf unterschiedlichen Seitenflächen der Kühleinrichtung angeordnet und miteinander mittels einer flexiblen Verbindungseinrichtung verbunden.

## Beschreibung

Die Erfindung betrifft eine Stromrichteranordnung mit Kühleinrichtung in einer dreidimensionalen Anordnung, wobei dies hier meint, dass verschiedene einzelne Stromrichterschaltungen der Stromrichteranordnung nicht wie häufig bekannt auf einer Ebene nebeneinander angeordnet sind. Ebenso betrifft die Erfindung ein besonders geeignetes Herstellungsverfahren für eine derartige Stromrichteranordnung.

Beispielhaft bildet die DE 44 43 498 C1 hierzu einen besonders weit entwickelten Stand der Technik. Hierin wird ein dynamisch angesteuerter Motor offenbart, der einen in der Längsachse des Motors vorgeschalteten Stromrichter aufweist. Besonders vorteilhaft an dieser Ausgestaltung ist die räumlich enge Kombination des Motors mit dem Stromrichter die somit eine insgesamt kompakte Einheit bilden. Hierzu ist der Stromrichter im Inneren einer konzentrischen Umhausung, die gleichzeitig als Kondensator ausgebildet ist, angeordnet. Ebenso vorteilhaft ist die Anordnung der Kühleinrichtung, die direkt in der Verlängerung der Längsachse des Motors angeordnet ist. Somit kann die Kühlung der Halbleitereinrichtung und des Motors geeignet kombiniert werden.

Nachteilig am vorgenannten Stand der Technik ist, dass hierfür keine Standardkomponenten, wie Kondensatoren und Leistungshalbleitermodule Einsatz finden können. Speziell der Kondensator ist gesondert für diesen Anwendungsfall auszubilden. Ebenso sind die im Inneren dieses Kondensators angeordneten Leistungshalbleiterschaltungsanordnungen speziell auszubilden und die gesamte Anordnung mit geeigneten Anschlusselementen zu verbinden.

Weiterhin ist aus der DE 10 2005 031 759 A1 eine Stromrichteranordnung mit einer Kühleinrichtung, einer Mehrzahl von Leistungshalbleitermodulen und einer Schaltungsanordnung zur Ansteuerung bekannt. Die Kühleinrichtung weist hier eine radialsymmetrische Ausgestaltung mit mehreren Kühlflächen auf. Auf diesen Kühlflächen sind die Leistungshalbleiterbauelemente dreidimensional angeordnet. Benachbart hierzu sind zugeordnete Ansteuerkomponenten und ebenfalls auf Kühlflächen auch Kondensatoren angeordnet.

Der vorliegenden Erfindung liegt die Aufgabe zugrunde eine Stromrichteranordnung mit einer Kühleinrichtung und mit einer dreidimensionalen Anordnung von Stromrichterschaltungen vorzustellen, die einen besonders kompakten Aufbau und gleichzeitig eine effiziente Kühlung der Stromrichterschaltungen gestattet, ebenso soll ein effizientes Herstellungsverfahren für eine derartige Stromrichteranordnung vorgestellt werden.

Die Aufgabe wird erfindungsgemäß gelöst, durch einen Gegenstand mit den Merkmalen des Anspruchs 1, sowie durch ein Verfahren gemäß Anspruch 9. Bevorzugte Ausführungsformen sind in den abhängigen Ansprüchen beschrieben.

Der erfinderische Gedanke geht aus von einer Stromrichteranordnung mit einer Kühleinrichtung, die eine Mehrzahl von Seitenflächen zur Anordnung von Stromrichterschaltungen, also Teilschaltungen der Stromrichteranordnung, aufweist. Die Kühleinrichtung weist weiterhin zwei Stirnflächen und eine Mehrzahl von Kühlmittelkanälen auf, wobei die Kühlmittelkanäle von der ersten zur zweiten Stirnfläche reichen und somit im Wesentlichen parallel zu den Seitenflächen verlaufen.

Erfindungsgemäß ist diese Kühleinrichtung als ein keramischer Formkörper ausgebildet, da dieser zusätzlich zu einer guten thermischen Leitfähigkeit den Vorteil aufweist elektrisch isolierend zu sein.

Die Stromrichterschaltungen sind auf mindestens zwei der Seitenflächen, mit unterschiedlichen Flächennormalen, des keramischen Formkörpers angeordnet und bilden somit eine dreidimensionale Anordnung aus. Jede dieser Stromrichterschaltungen weist jeweils eine Mehrzahl von voneinander elektrischen isolierten ersten Leiterbahnen auf. Auf diesen ersten Leiterbahnen sind Leistungshalbleiterbauelemente angeordneten und schaltungsgerecht innerhalb der Stromrichterschaltung verbunden.

Die verschiedenen Stromrichterschaltungen sind miteinander mittels mindestens einer flexiblen Verbindungseinrichtung schaltungsgerecht verbunden. Die mindestens eine Verbindungseinrichtung ist aus mindestens einer elektrisch isolierenden und einer elektrisch leitenden Folie ausgebildet, wobei vorteilhafterweise die elektrisch leitende Folie der Verbindungseinrichtung in sich strukturiert ist und somit einzelne zweite Leiterbahnen ausbildet. Weiterhin ist es besonders bevorzugt, wenn mindestens ein Bauteil einer Treiberschaltung auf einer weiteren elektrisch leitenden Folie der Verbindungseinrichtung angeordnet ist und diese Folie hierzu ebenfalls strukturiert ist um Leiterbahnen auszubilden. Hierbei werden in der Regel auch Durchkontaktierungen zwischen den leitenden Folien durch die isolierende Folie hindurch vorgesehen sein.

Auf Grund der elektrisch isolierenden Eigenschaft der Kühleinrichtung ist es möglich und vorteilhaft die ersten Leiterbahnen der jeweiligen Stromrichterschaltung direkt auf der zugeordneten Seitenfläche der Kühleinrichtung stoffschlüssig anzuordnen. Hierbei bieten sich verschieden Ausgestaltung an, die jede für sich genommen verschiedene Vorteile aufweist.

Eine erste Variante der stoffschlüssigen Verbindung von Leiterbahnen mit der Kühleinrichtung bilden Klebeverbindungen, wobei hierbei die elektrischen Eigenschaften des Kleber unerheblich sind, allerdings sollte er eine Wärmeleitfähigkeit von mindestens 10 W/(m·K) aufweisen.

Eine zweite Variante der stoffschlüssigen Verbindung von Leiterbahnen mit der Kühleinrichtung bilden Sinterverbindungen, wobei hier drucklose Varianten eines geringeren Fertigungsaufwands bedürfen, während druckbehaftete Varianten die höchste Wärmeleitfähigkeit aufweisen, allerdings aufwändiger herzustellen sind. Zudem ist für alle Sinterverbindungen notwendig, dass die Oberflächen der Verbindungspartner sinterfähig sind, was in der Regel eine Edelmetalloberfläche voraussetzt.

Die dritte Variante der stoffschlüssigen Verbindung von Leiterbahnen mit der Kühleinrichtung werden ausgebildet indem die ersten Leiterbahnen mittels eines Beschichtungsverfahrens auf der zugeordneten Seitenfläche der Kühleinrichtung angeordnet sind. Hierbei bieten sich verschiedenste Verfahren, beispielhaft Kaltgasspritzen, an.

Alternativ ist es ebenfalls möglich bekannte Substratträger, wie beispielhaft die häufig eingesetzten DCB (direct copper bonding) Substratträger mit hierauf angeordneten Stromrichterschaltung einzusetzen und den Substratträger mittels eines der oben genannten Verfahren auf der zugeordnete Seitenfläche der Kühleinrichtung stoffschlüssig zu verbinden.

Ein bevorzugtes erfindungsgemäßes Verfahren zur Herstellung einer oben genannten Stromrichteranordnung ist gekennzeichnet durch die Abfolge der folgenden Verfahrensschritte
- Bereitstellung einer Kühleinrichtung mit den genannten Eigenschaften.
- Herstellung eines sog. "Torsos" einer Baugruppe mindestens bestehend aus einer Verbindungseinrichtung zwischen einer Mehrzahl von Stromrichterschaltungen mit hierauf angeordneten Leistungshalbleiterbauelementen und diesen Stromrichterschaltungen. Es ist hierbei vorteilhaft in der Produktion des Torsos von der Verbindungseinrichtung auszugehen und hierauf die Leistungshalbleiterbauelemente anzuordnen. Es kann vorteilhaft sein die ersten Leiterbahnen ebenfalls als Teil des Torsos auszubilden oder diese getrennt auf der Kühleinrichtung vorzusehen.
- Stoffschlüssiges Verbinden des Torsos mit der Kühleinrichtung. Falls die ersten Leiterbahnen nicht teil des Torsos sind, müssen diese selbstverständlich vorher auf den zugeordneten Flächen angeordnet werden.

Als stoffschlüssige Verbindungen sind hier Klebeverbindungen oder Drucksinterverbindungen besonders bevorzugt. Besonders vorteilhaft bei Drucksinterverbindungen es auf zwei auf gegenüberliegenden Seitenflächen einer Kühleinrichtung angeordente Torsos gleichzeitig mit Druck zur Sinterverbindung zu beaufschlagen. Hierzu werden ein Druckstück und ein Druckgegenstück verwendet, die jeweils Druckelemente aufweisen, die einen quasihydrostatischen Druck auf den Torsos ausüben und somit auf zwei parallelen Seiten der Kühleinrichtung gleichzeitig die Sinterverbindung herstellen.

Der erfinderische Gedanke wird anhand der Ausführungsbeispiele der Fig. 1 bis 4 näher erläutert.

Fig. 1 zeigt eine Ausgestaltung einer Stromrichteranordnung nach dem Stand der Technik.

Fig. 2 zeigt eine dreidimensionale Ansicht einer ersten Ausgestaltung einer erfindungsgemäßen Stromrichteranordnung.

Fig. 3 zeigt eine dreidimensionale Ansicht einer zweiten Ausgestaltung einer erfindungsgemäßen Stromrichteranordnung.

Fig. 4 zeigt einen Schnitt durch ein dritte Ausgestaltung einer erfindungsgemäßen Stromrichteranordnung.

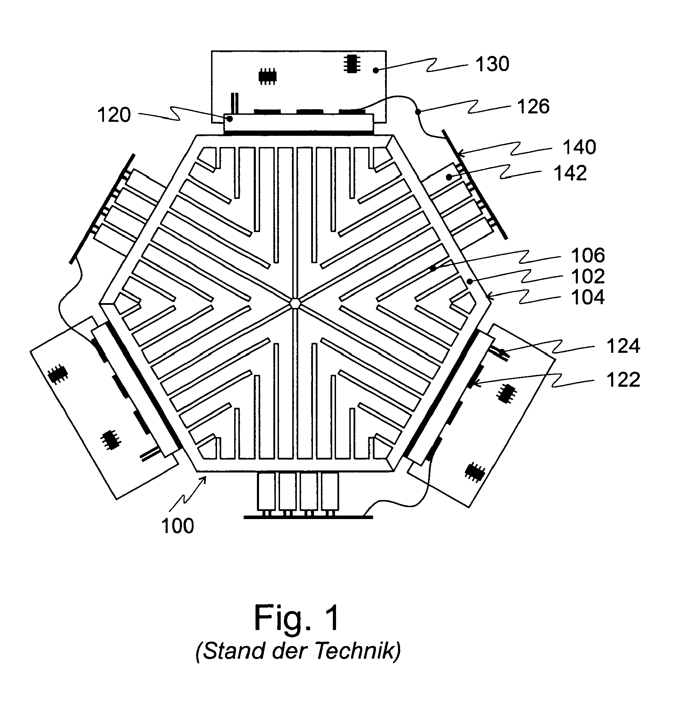

Fig. 1 zeigt eine Ausgestaltung einer Stromrichteranordnung nach dem Stand der Technik im Schnitt durch ihre Längsachse. Dargestellt ist hier eine hexagonale symmetrische Kühleinrichtung (100). Diese Kühleinrichtung (100) besteht hier aus drei identischen Metallformkörpern (102). Jeder dieser Metallformkörper (102) weist eine Kühlfläche (104) zur Anordnung zu kühlender Komponenten der Stromrichteranordnung auf. Diese Kühlflächen (104) der drei Metallformkörper (102) bilden die äußere Begrenzung der Kühleinrichtung (100). Die Metallformkörper (102) weisen weiterhin auf ihrer den Kühlflächen (104) abgewandten Seite Kühlmittel (106) auf. Diese Kühlmittel (106) sind hierbei plattenförmig mit unterschiedlicher Länge ausgebildet.

Die Kombination der drei Metallformkörper (102) bildet somit eine hexagonale, symmetrische Kühleinrichtung (100) zur Durchströmung mit Luft als Kühlmedium. Eine noch effizientere Kühlung kann mit flüssigen Kühlmedien erreicht werden. Hierzu müssen die Kühlmittel (106) geeignet modifiziert werden.

Auf drei der sechs identischen Kühlflächen (104) sind Halbleitereinrichtungen (120) angeordnet. Vorteilhafterweise sind die Halbleitereinrichtung (120) auf jeder zweiten Kühlfläche (104) angeordnet, um auf den jeweils dazwischen liegenden Kühlflächen weitere notwendige Komponenten der Stromrichteranordnung anzuordnen. Bei den Halbleitereinrichtungen handelt es sich um Leistungshalbleitermodule (120). Diese Leistungshalbleitermodule (120) sind mit ihrer zu kühlenden Oberfläche auf der Kühlfläche (104) der Kühleinrichtung (100) angeordnet. Die Anschlusselemente für Last- (122) und Hilfsanschlüsse (124) liegen auf der der Kühlfläche (104) gegenüberliegenden Seite des Leistungshalbleitermoduls (120).

Direkt benachbart zu den jeweiligen Leistungshalbleitermodulen (120) sind Platinen mit den Schaltungsanordnungen (130) zur Ansteuerung der Leistungshalbeitermodule (120) angeordnet. Vorteilhafterweise sind diese Platinen (130) stehend hinter den Leistungshalbleitermodulen (120) angeordnet um genügend Freiraum für die Verbindungselemente der Lastanschlüsse (122) zu gewähren. Die Verbindung zwischen den Hilfsanschlüssen (124) der Leistungshalbleitermodule (120) und der zugeordneten Schaltungsanordnung (130) zu Steuerung erfolgt nach dem Stand der Technik mittels reversibler Verbindungselemente, wie Steck- und / oder Schraubkontakte. Vorteilhafterweise sind die Platinen (130) der Schaltungsanordnung zur Ansteuerung der Leistungshalbleitermodule (120) zu deren Schutz beispielhaft gegen Staub und Feuchtigkeit geeignet gekapselt.

Die weiteren Komponenten der Stromrichteranordnung, speziell die Kondensatoren (142) des Zwischenkreises (140), finden auf den Kühlflächen (104) zwischen denjenigen der Leistungshalbleitermodule (120), Platz. Dies ist besonders vorteilhaft, da hierbei die Verbindung (126) der Lastanschlüsse (122) der Leistungshalbleitermodule (120) mit dem Zwischenkreis (140) im Besonderen der zugehörigen Kondensatoren (142) niederinduktiv ausgebildet werden kann und gleichermaßen die Stromwege kurz gehalten werden können.

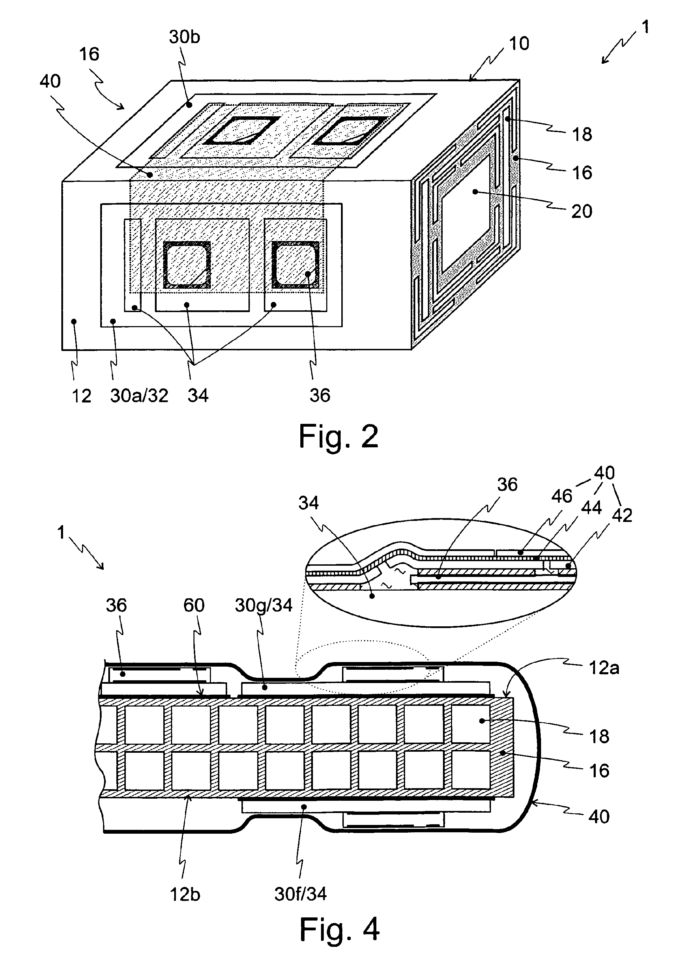

Fig. 2 zeigt eine dreidimensionale Ansicht einer ersten Ausgestaltung einer erfindungsgemäßen Stromrichteranordnung (1). Dargestellt ist eine Kühleinrichtung (10) in Ausgestaltung eines keramischen Formkörpers, hier eines Quaders, mit zwei seitlich dargestellten Stirnflächen (16). Zu Kühlung mit einem Kühlmedium wird diese Kühleinrichtung (10) durchflossen. Hierzu weist der keramische Quader Kühlmedienkanäle (18) auf, die von einer zur anderen Stirnfläche (16) durch den Quader hindurch reichen. Diese Kühlmedienkanäle (18) weisen hier eine spezielle vorteilhafte Ausgestaltung zur Durchströmung mit einem gasförmigen Kühlmedium, meist Luft, auf. Durch geeignete Ausgestaltung kann der keramische Formkörper, auch im Vergleich zu bekannten metallischen Kühleinrichtung, leicht bei gleichzeitig größerer Stabiltät ausgebildet werden.

Auf zwei der Seitenflächen (12) des keramischen Quaders sind in dieser Ausgestaltung die Stromrichterschaltungen (30 a/b) angeordnet, wobei diese keine Beschränkung der Allgemeinheit bedeutet. Es können auf allen Seitenflächen (12) eine oder mehrere Stromrichterschaltungen (30) angeordnet sein. Die Stromrichterschaltungen (30 a/b) dieser ersten Ausführungsform sind in bekannter Weise auf einem Substratträger (32) angeordnet.

Dieser Substratträger (32) kann ebenfalls aus einem keramischen Material ausgebildet sein und auf seiner der Kühleinrichtung (10) abgewandten Seite eine Mehrzahl erster Leiterbahnen (34) aufweisen, die wiederum die Leistungshalbleiterbauelemente (36) tragen. Eine Anordnung einer flächigen Metallkaschierung auf der den Leistungshalbleiterbauelement abgewandten Seite des Substratträgers ist aus dem Stand der Technik hinlänglich bekannt, hier allerdings nicht zwangsläufig notwendig.

Der Substratträger (32) ist in dieser Ausgestaltung in Form einer Klebeverbindung mit der Kühleinrichtung (10) stoffschlüssig verbunden. Als Medium der Klebeverbindungen eigenen sich hier bekannte Klebstoffe mit einer Wärmeleitfähigkeit von mehr als 10 W/(K·m) oder beispielhaft auch präkeramische Polymere.

Die schaltungsgerechte Verbindung innerhalb einer Stromrichterschaltung (30) ist hier wie gleichzeitig auch die schaltungsgerechte Verbindung der Stromrichterschaltungen (30 a/b) untereinander mittels einer einzigen Verbindungseinrichtung (40) ausgebildet. Eine Aufteilung auf eine Mehrzahl derartiger Verbindungseinrichtungen ist möglich allerdings aufwändiger in der Herstellung.

Als Verbindungseinrichtung (40) hat sich ein Folienverbund von mindestens einer elektrisch leitenden und einer elektrisch isolierend Folie als sinnvoll erwiesen. Eine auch als Torso zu bezeichnende, Baugruppe gebildet aus mindestens zwei Stromrichterschaltungen (30 a/b) mit einer Verbindungseinrichtung (40) kann in einem einfachen Verfahren auf der Kühleinrichtung (10) angebracht werden. Hierbei ist die Flexibiliät der Verbindungseinrichtung (40) wesentlich um geringfügige Lagetoleranzen der Stromrichterschaltungen (30 a/b) auf den Seitenflächen (12) ausgleichen zu können.

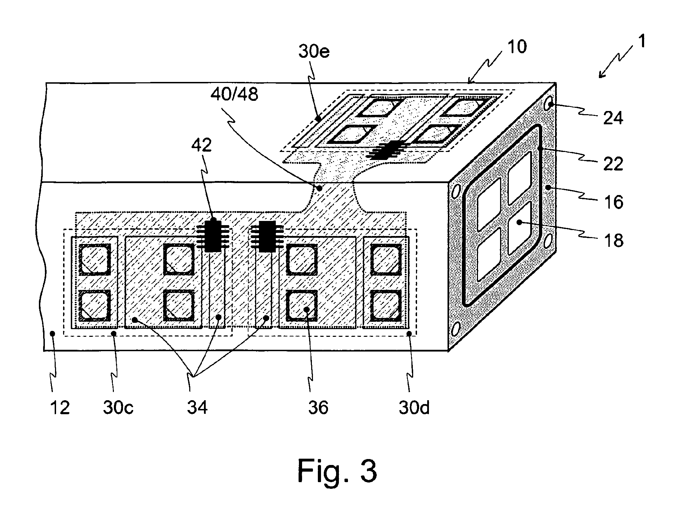

Fig. 3 zeigt eine dreidimensionale Ansicht einer zweiten Ausgestaltung einer erfindungsgemäßen Stromrichteranordnung (1), die Kompaktheit mit besonderer Leistungsfähigkeit verbindet. Im Gegensatz zur Ausgestaltung gemäß Fig. 2 wird hier einerseits als Kühlmedium eine Flüssigkeit eingesetzt und andererseits bei den einzelnen Stromrichterschaltungen auf explizite Substratträger verzichtet.

Der keramische Formkörper der Kühleinrichtung (10) weist hier wiederum zwischen seinen Stirnseiten (16) verlaufende Kühlmedienkanäle (18) auf. Diese sind hier allerdings für die Durchströmung mit einem flüssigen, vorzugsweise hauptsächlich aus Wasser bestehenden, Kühlmedium optimiert. Weiterhin weisen diese Stirnseiten (16) Verbindungsmittel (24) und Dichteinrichtungen (22) auf um an einen externen Kühlmedienkreislauf angeschlossen zu werden.

Die Verbindungseinrichtung (40) der Stromrichterschaltungen (30 c/d/e) ist hier gegenüber Fig. 2 dahingehend weiter gebildet, dass sie eine weitere elektrisch leitende und in sich strukturierte Schicht (vgl. Fig. 4, 46) aufweist. Somit ergibt sich der Schichtaufbau, ausgehend von einer Stromrichterschaltung (32) zu einer strukturierten zweite Leiterbahnen ausbilden leitenden Folie (vgl. Fig. 4, 42) einer isolierenden Folie (vgl. Fig. 4, 44) und einer weiteren leitenden Folie (vgl. Fig. 4, 46). Auf dieser Schicht, die ebenfalls aus der weiteren leitenden und strukturierten Folie besteht, sind weitere Bauelemente (42), beispielhaft zur Ansteuerung der Leistungshalbleiterbauelement (36) der Stromrichterschaltungen (30 c/d/e) oder auch, allerdings nicht dargestellt, Sensoren zu Bestimmung verschiedener Betriebsparameter angeordnet. Weiterhin weist die Verbindungseinrichtung (40) im Bereich zwischen den Stromrichterschaltung (30 d/e) einen verjüngten Bereich (48) auf, der die Flexibilität gegenüber Fertigungstoleranzen abermals steigern kann.

Die ersten Leiterbahnen (34) der jeweiligen hier dargestellten frei Stromrichterschaltungen (30 c/d/e) sind direkt auf der elektrisch isolierenden keramischen Kühleinrichtung (10) angeordnet. Hierzu wird in dieser Ausgestaltung ein Beschichtungsverfahren verwendet. Grundsätzlich sind hier die bekannten chemischen, mechanischen, thermischen und thermo-mechanischen Beschichtungsverfahren geeignet. Als besonders vorteilhaft hat sich allerdings Kaltgasspritzen als Beschichtungsverfahren erwiesen.

Durch diese direkte Anbindung der ersten Leiterbahnen (34) der Stromrichterschaltungen (30 c/d/e) auf den Seitenflächen (12) der Kühleinrichtung (10) ist der Wärmeübergang von den Leistungshalbleiterbauelementen (36) über die ersten Leiterbahnen (34) auf die Kühleinrichtung (10) und dann auf das Kühlmedium besonders effizient.

Fig. 4 zeigt einen Schnitt durch eine dritte Ausgestaltung einer erfindungsgemäßen Stromrichteranordnung (1). Dargestellt ist hier ein ebenfalls quaderförmiger allerdings flach ausgebildeter keramischer Formkörper als Kühleinrichtung (10). Dieser weist wiederum zwischen seinen Stirnseiten (16) verlaufende Kühlmedienkanäle (18) auf. Die Stromrichterschaltungen (30 f/g) sind hier auf den beiden größeren Seitenflächen (12 a/b) der Kühleinrichtung (10) angeordnet und mit einer bereits beschrieben Verbindungseinrichtung (40) verbunden. Diese Verbindungseinrichtung (40) weist die zwei strukturierte Folien (42, 46) und eine dazwischen angeordnete isolierende Folie (44) auf, wobei die erste isolierende Folie (42) die oben genannten zweiten Leiterbahnen ausbildet.

Die einzelnen ersten Leiterbahnen (34) der Stromrichterschaltungen (10) sind hier allerdings mittels eins Sinterverfahrens mit den Seitenflächen (12 a/b) der Kühleinrichtung (10) verbunden. Hierzu bieten sich zwei Sinterverfahren an, einerseits das drucklose sintern und andererseits das Drucksintern mit bekannten Drücken in der Größenordnung von 50 MPa. Hier ist es besonders bevorzugte in einem Herstellungsschritt die beiden Stromrichterschaltungen (30 f/g) gleichzeitig mittels einer Sintermetallschicht (60) mit der Kühleinrichtung (10) zu verbinden.

## Patentansprüche

1. Stromrichteranordnung (1)
mit einer Kühleinrichtung (10) mit einem keramischen Formkörper, der eine Mehrzahl von Seitenflächen (12), zwei Stirnflächen (16) und eine Mehrzahl von Kühlmedienkanälen (18) aufweist, wobei die Kühlmedienkanäle (18) von der ersten zur zweiten Stirnfläche (16) reichen und
mit einer Mehrzahl von Stromrichterschaltungen (30) mit jeweils einer Mehrzahl von voneinander elektrischen isolierten ersten Leiterbahnen (34) und auf mindestens einem auf einer dieser Leiterbahnen (34) angeordneten und schaltungsgerecht verbundenem Leistungshalbeiterbauelement (36), wobei
mindestens zwei Stromrichterschaltungen (30) auf unterschiedlichen Seitenflächen (12) der Kühleinrichtung (10) angeordnet sind und miteinander mittels einer flexiblen Verbindungseinrichtung (40), ausgebildet aus mindestens einer elektrisch isolierenden (44) und einer elektrisch leitenden (42) Folie, verbunden sind.

2. Stromrichteranordnung nach Anspruch 1, wobei
die mindestens eine erste elektrisch leitenden Folie (42) der Verbindungseinrichtung in sich strukturiert ist und somit einzelne zweite Leiterbahnen ausbildet und mindestens ein Bauteil einer Treiberschaltung auf einer weiteren elektrisch leitenden Folie (46) der Verbindungseinrichtung (40) angeordnet ist und diese Folie (46) hierzu ebenfalls strukturiert ist.

3. Stromrichteranordnung nach Anspruch 1, wobei
die ersten Leiterbahnen (34) der jeweiligen Stromrichterschaltung (30) direkt auf der zugeordneten Seitenfläche (12) der Kühleinrichtung (10) angeordnet sind.

4. Stromrichteranordnung nach Anspruch 3, wobei
die ersten Leiterbahnen (34) mittels eines thermisch leitfähigen Klebstoffes mit einer Wärmeleitfähigkeit von mindestens 10 W/(m·K) auf die Seitenfläche (12) der Kühleinrichtung (10) stoffschlüssig angeordnet sind.

5. Stromrichteranordnung nach Anspruch 3, wobei
die ersten Leiterbahnen (34) mittels eines Sinterverfahrens auf der zugeordneten Seitenfläche (12) der Kühleinrichtung (10) stoffschlüssig angeordnet sind und hierzu die jeweiligen Verbindungsflächen eine Edelmetalloberfläche aufweisen.

6. Stromrichteranordnung nach Anspruch 3, wobei
die ersten Leiterbahnen (34) mittels eines Beschichtungsverfahrens auf der zugeordneten Seitenfläche (12) der Kühleinrichtung (10) angeordnet sind.

7. Stromrichteranordnung nach Anspruch 1, wobei
die ersten Leiterbahnen (34) der jeweiligen Stromrichterschaltung (30) auf einem Substratträger (32) angeordnet sind und dieser mit der zugeordnete Seitenfläche (12) der Kühleinrichtung (10) stoffschlüssig verbunden ist.

8. Stromrichteranordnung nach Anspruch 1, wobei
die Stirnflächen (16) geeignete Dichteinrichtungen (22) aufweisen und die Kühlmedienkanäle (18) mit einem flüssigen Kühlmedium durchfließbar sind.

9. Verfahren zur Herstellung einer Stromrichteranordnung (1) nach einem der vorgenannten Ansprüche, **gekennzeichnet durch** die Abfolge der folgenden Verfahrensschritte
• Bereitstellung einer Kühleinrichtung (10)
• Herstellung eines Torsos mindestens bestehend aus einer Verbindungseinrichtung (40) zwischen einer Mehrzahl von Stromrichterschaltungen (30) mit hierauf angeordneten Leistungshalbleiterbauelementen (40).
• Stoffschlüssiges Verbinden des Torsos mit der Kühleinrichtung (10).

10. Verfahren nach Anspruch 9, wobei
die stoffschlüssige Verbindung mittels Drucksintern hergestellt wird und hierbei auf zwei auf gegenüberliegenden Seitenflächen (12 a/b) einer Kühleinrichtung (10) angeordnete Torsos gleichzeitig Druck eingeleitet wird indem ein Druckstück und ein Druckgegenstück verwendet werden, die jeweils Druckelemente aufweisen, die einen quasihydrostatischen Druck auf den Torsos ausüben und somit auf zwei parallelen gegenüberliegenden Seiten (12 a/b) der Kühleinrichtung (10) gleichzeitig die Sinterverbindung hergestellt wird.
